# EUROPEAN PATENT SPECIFICATION

(11) **EP 0 740 306 B1**
(45) Date of publication and mention of the grant of the patent: **26.07.2000**
(21) Application number: 96111221.6
(22) Date of filing: 30.01.1992
(51) Int. Cl.: G11C 16/04, G11C 16/06, H01L 29/788

(54) **Method of programming a semiconductor memory device**
Verfahren zur Programmierung einer Halbleiterspeicheranordnung
Méthode de programmation d'un dispositif semi-conducteur de mémoire

(30) Priority: 31.01.1991 BE 9100091
(43) Date of publication of application: 30.10.1996
(62) Divisional of application: 92870016.0
(73) Proprietor: INTERUNIVERSITAIR MICROELEKTRONICA CENTRUM VZW, 3001 Leuven (BE)
(72) Inventor: Van Houdt, Jan, 3212 Lubbeek (BE); Groeseneken, Guido, 3000 Leuven (BE); Maes, Herman, 3360 Bierbeek (BE)
(74) Representative: Vanderperre, Robert

(56) References cited:
- EP-A- 0 228 761
- US-A- 4 794 565
- PATENT ABSTRACTS OF JAPAN vol. 12, no. 330 (E-655) <3177> 07 September 1988 & JP-A-63 093158 (TOSHIBA CORP) 23 April 1988
- PATENT ABSTRACTS OF JAPAN vol. 8, no. 155 (E-256) [1592] , 19 July 84 1984 & JP-A-59 058868 (NIPPON DENKI K.K.), 4

## Description

The present invention relates to electrically erasable and programmable semiconductor memory devices (EEPROMs) and in particular a method of programming such memory devices.

Nowaday microprocessors require fast programmable and fast readable memory devices (among others EEPROMs) that generally use dual gate MOS transistors. In conventional EPROM memory devices, the programming mechanism is based on a channel electron injection mechanism. In order to program a transistor memory cell high voltages should be applied to the gate and the drain of the transistor. This results in a high power consumption, which requires the use of an extra voltage supply to program the device.

EP-A-0228761 discloses a transistor structure which can be programmed and erased without the need for an external power supply. This is a typical example of a large class of electrically erasable memory devices which use tunneling for both programming and erasure. The main disadvantages of this option are the requirement of high programming voltages to be generated on the chip (which would be 20 V in the case of EP-A-0228761), long programming times (in the order of milliseconds) and a complex manufacturing technology (at least three polysilicon layers and two tunnel dielectrics are required in the case of EP-A-0228761). Therefore, this prior art device is unsuitable for low cost manufacturing of fast-programmable non-volatile memory devices.

US-A-4,794,565 discloses another alternative transistor structure which allows the programming operation to be performed using a low drain voltage and a high gate voltage. This known device includes an extra polysilicon gate that is located adjacent the stacked dual gate transistor structure above the diffused source region. A high lateral electric field is thereby generated adjacent the source when a high voltage is applied to the gate at the source side of the device. Said lateral electric field combines with a high vertical field, resulting in a faster programming operation.

The drawback of this known device is that the formation of the extra polysilicon gate requires a complex manufacturing technology that is not compatible with the standard CMOS floating gate technology. As a result, this prior art device is unsuitable for low cost manufacturing of non volatile programmable memory devices.

It is an object of this invention to overcome the drawbacks referred to above by an MOS transistor structure which is suitable for being programmed within a microsecond with the aid of a standard TTL supply and which can be manufactured using a standard CMOS technology.

Another object of this invention is to provide a method of programming a fast EEPROM cell so as to substantially increase the programming speed.

There is provided a a floating gate transistor comprising a semiconductor substrate including a source region, a drain region and a channel region extending between said source and drain regions, a floating gate extending over a portion of said channel at the drain side of the device and being insulated from said channel region by a thin oxide layer, said floating gate having an extension extending outside said channel region in a direction perpendicular to the channel length direction, said extension being insulated from the silicon substrate by a thick oxide layer, and having a sufficient length to form a capacitor outside the channel region, a control gate extending over a portion of said channel at the source side of the device and entending over a portion of said floating gate insulated therefrom by a dielectric layer, and a program gate (19) extending over said floating gate extension and being insulated therefrom by a dielectric layer so as to form a capacitor with said floating gate extension, said capacitor being large enough to couple a voltage to the floating gate, said program gate and said control gate having lateral edges facing each other in a spaced apart relationship.

A method of programming said floating gate transistor according to the invention is disclosed. The method comprises the steps of applying a high voltage to said program gate thereby capacitively coupling a high voltage to said floating gate extension, applying a low voltage to said control gate and applying a voltage which can be realised without an external voltage supply to said drain region, to thereby cause a very high hot-electron injection towards said floating gate while achieving a programming of said transistor without the need for an external voltage supply. Said method achieves, within a microsecond or faster, a programming of said transistor without the need for an external voltage supply.

By using this method, fast programming operations can be achieved using low drain voltage only, thus without need of an external voltage supply.

Further, because programming is achieved with the control gate at a very low voltage close to the threshold voltage of the built-in select transistor, the drain current during programming is significantly reduced as compared to conventional devices, resulting in a reduction of power consumption and voltage drop along the bit lines during programming.

The invention is illustrated in the accompanying drawings in which :
Figure 1 is a schematic top view of a device according to the invention;
Figure 2 is a sectional view along line II-II of Figure 1;
Figure 3 is a sectional view along line III-III of Figure 1;
Figure 4 is a plot of gate current versus gate voltage;
Figure 5 is a plot of gate current versus gate voltage for different channel lengths;
Figure 6 is a typical plot of threshold voltage shift versus programming time for different drain voltages;
Figure 7 is a plot of threshold voltage and erase time for different drain voltages;
Figure 8 shows the threshold voltage window as a function of the number of program/erase cycles;
Figure 9 shows the high and the low threshold levels as a function of time during a bake test at 300°C.

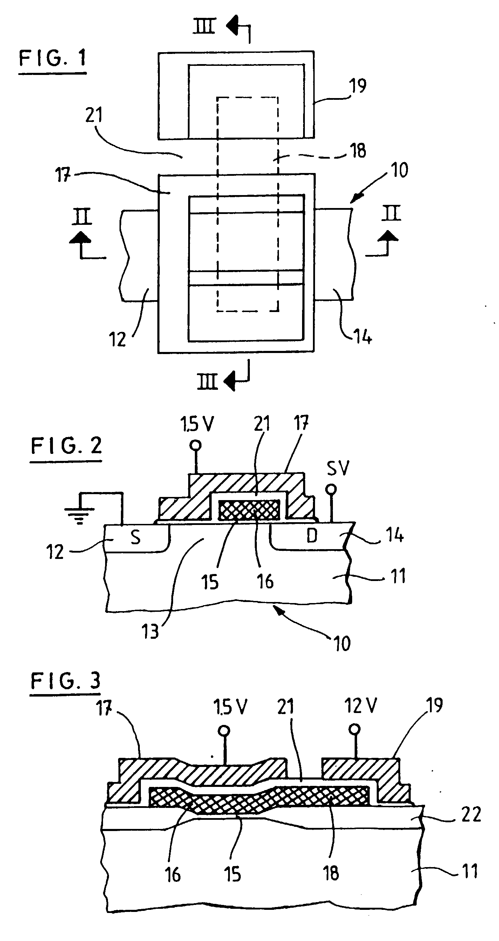

Referring to Figs. 1 to 3, the transistor structure according to the invention has a semiconductor substrate 11 with a source region 12, a channel region 13 and a drain region 14 formed therein, and a floating gate 16 made of a polysilicon layer that extends over a portion of the channel region 13 and is insulated therefrom by a thin tunnel oxide layer 15. A control gate 17 overlies the floating gate 16 from above the source region 12 to above the drain region 14 through an interpoly oxide layer 21. The floating gate 16 has an extension 18 insulated from the semiconductor substrate 11 through a dielectric layer 22.

A program gate 19 is formed outside the active area 10 of the semiconductor substrate 11. The program gate 19 overlies the extension 18 of the floating gate through the interpoly oxide layer 21 so as to form an electric capacitor with said extension 18. The object of the program gate 19 is to couple a voltage to the floating gate thereby programming the device through an enhanced electron injection mechanism. The program gate 19 may be formed from the same polysilicon layer as the control gate 17.

Exemplary devices have been fabricated in a 1.25 µm CMOS technology with a transistor width of 2.5 µm, a floating gate length of 1.2 µm and a control gate length of 1.5 µm. The width of the program gate was 3.5 µm. The total cell as used in a memory matrix had an area ranging about 100 µm². The tunnel oxide layer had a thickness of 10 nm and the insulating oxide layer between the control gate and the silicon substrate had a thickness of 16 nm.

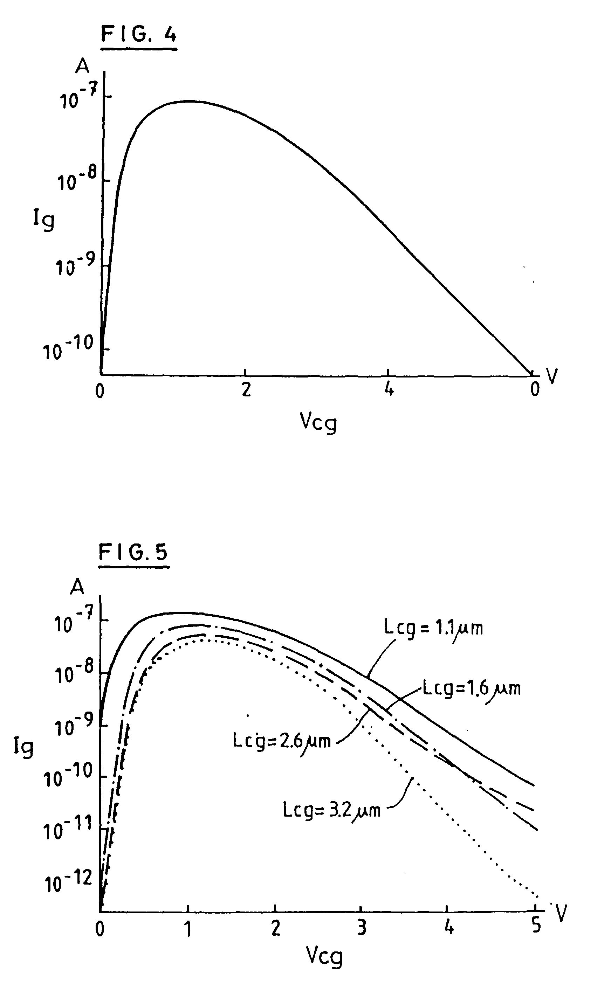

In use, a low voltage Vcg is applied to the control gate 17, a high voltage Vpg is applied to the program gate 19 and a low voltage Vd is applied to the drain region. Typical voltage values according to the invention are Vcg = 1.2 V, Vpg = 12 V and Vd = 5 V. The program gate 19 thereby couples a high voltage onto the floating gate 16 (e.g. a voltage of 9 V with the typical values shown above), which results in a very high hot-electron generation in the channel region between the control gate and the floating gate. It is to be noted that high gate current can be obtained with a drain voltage of only 5 V. Fig. 4 shows the gate current Ig measured for different control voltages Vcg. A current of 10 nA per µm device width has been measured with the typical voltage values shown above. Thus, writing data in a memory cell according to the invention can be achieved within 1 microsecond using only 5 V at the drain. Fast programming is thereby provided without the need for an external voltage supply.

An advantage of the device according to this invention resides in that the gate current Ig is only weakly depending on the actual length of the transistor channel as illustrated in Fig. 5 which shows plots of the gate current Ig as a function of the control gate voltage Vcg with different actual lengths of the transistor channel. As a result, the operation of the device is insensitive to manufacturing variations, which makes the device very interesting from the point of view of process control.

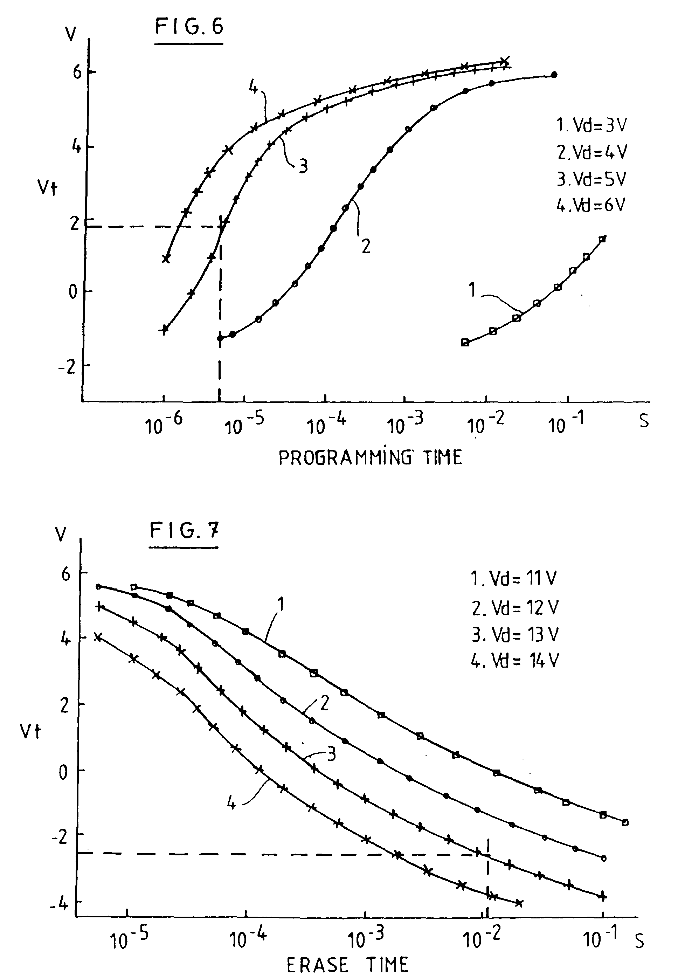

Fig. 6 shows the threshold voltage shift Vs programming time with a control gate voltage Vcg of 1.4 V and a program gate voltage Vpg of 12 V for different drain voltages Vd as shown in the Figure. In the case of Vd=5V, it is seen that the threshold voltage at the beginning of the programming phase is equal to -2.33 and that a threshold voltage window of 4 V is already obtained after 4 microseconds. This proves that programming is very fast even when using a 10 nm tunnel oxide layer (which provides better retention) and a lower coupling factor (for a smaller coupling area).

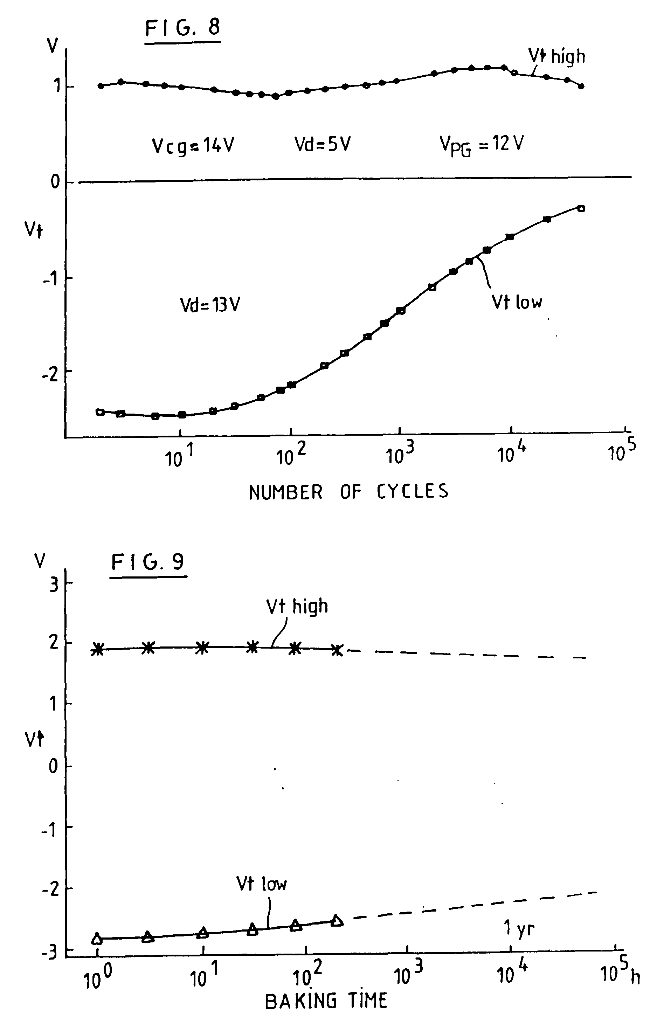

Erasure of the device is achieved by applying a high voltage to the drain while keeping the control gate 17 and the program gate 19 grounded. The high field which appears across the thin oxide layer 15 underneath the floating gate forces the stored electrons to move back towards the drain junction by the well-known Fowler-Nordheim tunneling mechanism, thereby decreasing the threshold voltage again to lower values. Fig. 7 is a plot of the threshold voltage Vt versus erase time (s) for drain voltages Vd of eleven, twelve, thirteen and fourteen volts. Starting from an initial threshold voltage of 6 V, the device can be erased to the low threshold state in 10 milliseconds with a drain voltage Vd of 13 V.

Reading out the device is achieved by applying a low voltage to the drain 14 and to the program gate 19 while keeping the control gate voltage Vcg well above the threshold level of the built-in select transistor. Since the program gate voltage is low, the enhanced electron injection mechanism is turned off thereby avoiding the soft write phenomenon during a read-out operation. This allows high read current to be obtained by a proper choice of the program gate voltage and thus higher read-out speed.

It is to be noted that programming and erasing the device according to the invention occurs at different locations along the transistor channel, which improves the device endurance.

Fig. 8 shows the threshold voltage window as a function of the number of program/erase cycles for exemplary devices with the operating conditions as shown in the Figure. The upper curve illustrates the high threshold level, the lower curve illustrates the low threshold level. It is seen that the high threshold level stays high during the entire test. This implies that the maximum number of cycles is determined by the low threshold level only.

Using an asymmetrical threshold voltage window (e.g. from -3 V to 1 V), this typical feature of the device according to the invention can be exploited in order to raise the maximum allowable number of cycles. With a read-out voltage of 0 V at the program gate (which is very convenient from the circuit designer's point of view), the device operating as shown in Fig. 8 can sustain up to at least 10,000 program/erase cycles without read-out failures.

A further basic feature of a non-volatile memory device is the data retention, that is the ability for the device to retain the same information for a long period of time. Fig. 9 shows the high and low threshold levels of exemplary devices according to the invention as a function of time during a bake test at 300°C. The devices tested were unoptimized devices having a 8.2 nm tunnel oxide layer. The initial threshold voltage window was 4.75 V wide. After 200 hours, the threshold voltage window was still 4.5 V wide. Extrapolating the curves towards the next decades shows an expected data retention time of at least 10 years.

From the foregoing it is apparent that the structure according to the invention offers many advantages over prior art non-volatile memory designs. To summarize, the invention provides a new structure which allows fast writing operations to be achieved using low drain voltage only, thus without needing an external voltage supply.

Because programming is achieved with the control gate at a very low voltage close to the threshold voltage of the built-in select transistor, the drain current during programming is significantly reduced as compared to conventional devices, resulting in a reduction of power consumption and voltage drop along the bit lines during programming.

Further, the device can endure a very high number of program/erase cycles without read-out failures, viz. a number as high as 100,000 program/erase cycles under ideal conditions. Also, the device affords very good data retention.

Since read-out operation is achieved with a low voltage at the program gate, soft-write phenomenon is avoided and the device affords higher read-out speed.

The device allows selective erasure and over-erasure, whereby a symmetrical threshold voltage window may be used.

As to the manufacturing feature, the invention makes it possible to use low-cost standard CMOS technology.

In view of the above disclosure, any and all modifications, variations or equivalent arrangements which may occur to those skilled in the art should be considered to be within the scope of the invention as defined in the appended claims.

## Claims

1. Method of programming a polysilicon floating gate transistor, said transistor comprising a semiconductor substrate (11) including a source region (12), a drain region (14) and a channel region (13) extending between said source and drain regions, a polysilicon floating gate extending over a portion of said channel region at the drain side of the device and being insulated from said channel region (13) by a thin oxide layer (15), said polysilicon floating gate having an extension (18) extending outside said channel region (13) in a direction substantially perpendicular to the channel length direction, said extension (18) being insulated from the silicon substrate (11) by a thick oxide layer (22), and having a sufficient length to form a capacitor outside the channel region, a control gate (17) extending over a portion of said channel at the source side of the device and extending over a portion of said polysilicon floating gate (16) insulated therefrom by a dielectric layer, and a program gate (19) extending over said polysilicon floating gate extension (18) and being insulated therefrom by a dielectric layer so as to form a capacitor with said polysilicon floating gate extension, said capacitor being large enough to couple a voltage to the polysilicon floating gate (16), said program gate and said control gate being spaced apart, the method comprising the steps of:
applying a high voltage to said program gate thereby capacitively coupling a high voltage to said polysilicon floating gate extension;
applying a low voltage to said control gate; and
applying a voltage which can be realized without an external voltage supply to said drain region,
to thereby cause a very high hot-electron injection towards said floating gate while achieving a programming of said transistor without the need for an external voltage supply.

## Patentansprüche

1. Verfahren zum Programmieren eines Polysiliciumtransistors mit schwimmendem (floating) Gate, wobei der Transistor folgende Merkmale umfaßt:
ein Halbleitersubstrat (11) mit einem Source-Bereich (12), einen Drain-Bereich (14) und einen Kanalbereich (13), der sich zwischen den Source- und den Drain-Bereichen erstreckt,
ein schwimmendes Polysiliciumgate, das sich über einen Teil des Kanalbereichs an der Drain-Seite der Einrichtung erstreckt und von dem Kanalbereich (13) mittels einer dünnen Oxidschicht (15) isoliert ist,
das schwimmende Polysiliciumgate weist einen Fortsatz (18) auf, der sich außerhalb des Kanalbereichs (13) in einer Richtung im wesentlichen senkrecht zur Kanallängenrichtung erstreckt,
der Fortsatz (18) ist mittels einer dicken Oxidschicht (22) vom Siliciumsubstrat (11) isoliert und weist eine ausreichende Länge auf, um einen Kondensator außerhalb des Kanalbereichs zu bilden,
ein Steuer-Gate (17) erstreckt sich über einen Teil des Kanals an der Source-Seite der Einrichtung und erstreckt sich über einen Teil des schwimmenden Polysiliciumgates (16), welches von diesem mittels einer dielektrischen Schicht isoliert ist, und
ein Programmier-Gate (19) erstreckt sich über den Fortsatz (18) des schwimmenden Polysiliciumgates und wird von diesem mittels einer dielektrischen Schicht isoliert, um so einen Kondensator mit dem Fortsatz des Polysiliciumgates zu bilden, wobei der Kondensator groß genug ist, um eine Spannung in das Polysilicium-Floatinggate (16) einzukoppeln;
das Programmier-Gate und das Steuer-Gate sind voneinander beabstandet, wobei das Verfahren folgende Schritte umfaßt:
an das Programmier-Gate wird eine hohe Spannung angelegt, wodurch eine hohe Spannung in den Fortsatz des schwimmenden Polysiliciumgates kapazitiv eingekoppelt wird;
eine niedrige Spannung wird an das Steuer-Gate angelegt; und
eine Spannung, die ohne externe Spannungsversorgung realisiert werden kann, wird an den Drain-Bereich angelegt, wodurch eine starke Injektion mit sehr heißen Elektronen zum schwimmenden Gate bewirkt wird, während eine Programmierung des Transistors erreicht wird, ohne daß eine externe Spannungsversorgung benötigt wird.

## Revendications

1. Procédé de programmation d'un transistor à gâchette flottante en polysilicium, ledit transistor comprenant un substrat semi-conducteur (11) ayant une région source (12), une région drain (14) et une région canal (13) s'étendant entre lesdites régions source et drain, une gâchette flottante en polysilicium s'étendant au-dessus d'une partie de ladite région canal du côté drain du dispositif et étant isolée de ladite région canal (13) par une mince couche d'oxyde (15), ladite gâchette flottante en polysilicium ayant une extension (18) s'étendant en dehors de la région canal (13) dans une direction essentiellement perpendiculaire à la direction longitudinale du canal, ladite extension (18) étant isolée du substrat de sylicium (11) par une couche d'oxyde épaisse (22), et ayant une longueur suffisante pour former une capacité en dehors de la région canal, une électrode de contrôle (17) s'étendant au-dessus d'une partie du canal précité du côté source du dispositif et s'étendant au-dessus d'une partie de la gâchette flottante (16) en polysilicium dont elle est isolée par une couche diélectrique, et une électrode de programmation (19) s'étendant au-dessus de ladite extension (18) de la gâchette flottante en polysilicium et étant isolée de celle-ci par une couche diélectrique de manière à former une capacité avec l'extension de la gâchette flottante en polysilicium, ladite capacité étant suffisamment grande pour appliquer une tension à la gâchette flottante (16) en polysicium, l'électrode de programmation et l'électrode de commande étant espacées l'une de l'autre, le procédé comprenant les étappes de :
application d'une haute tension à l'électrode de programmation appliquant ainsi de manière capacitive une haute tension à ladite extension de la gâchette flottante en polysilicium;
application d'une basse tension à ladite électrode de commande; et
application d'une tension qui peut être réalisée sans source de tension extérieure à ladite région drain,
provoquant ainsi une très intense injection d'électrons vers la gâchette flottante tout en obtenant une programmation du transistor sans la nécessité d'une source de tension extérieure.
